# EUROPEAN PATENT APPLICATION

(11) **EP 4 451 824 A1**
(43) Date of publication of application: **23.10.2024**
(21) Application number: 22956715.1
(22) Date of filing: 29.08.2022
(51) Int. Cl.: H10K 50/80

(54) **DISPLAY SUBSTRATE AND TOUCH-CONTROL DISPLAY APPARATUS**

(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: WANG, Wei, Beijing 100176 (CN); WEN, Ping, Beijing 100176 (CN); ZHANG, Yi, Beijing 100176 (CN)
(74) Representative: Isarpatent
(86) International application number: PCT/CN2022/115462
(87) International publication number: WO 2024/044879

(57) **Abstract**

The present disclosure provides a display substrate and a touch display device. The display substrate includes a base substrate and a functional film layer on the base substrate. The functional film layer is configured for reflecting light emitted from outside to the functional film layer. The display substrate further includes an encapsulation layer and a blocking layer; the blocking layer is on a side of the functional film layer facing away from the base substrate; the encapsulation layer is between the blocking layer and the functional film layer; an orthographic projection of the blocking layer onto the base substrate at least partially overlaps with an orthographic projection of the functional film layer onto the base substrate.

## Description

### TECHNICAL FIELD

The present disclosure relates to the field of display technologies, in particular to a display substrate and a touch display device.

### BACKGROUND

With continuous development of display technologies, touch display products are widely applied in multiple fields. The touch display product has both touch function and display function. When a picture is displayed on the touch display product, control of functions of the touch display product can be realized by touching on a screen of the touch display product.

### SUMMARY

An object of the present disclosure is to provide a display substrate and a touch display device.

In order to achieve the above object, the present disclosure provides the following technical solutions.

According to a first aspect of the present disclosure, a display substrate is provided and includes: a base substrate and a functional film layer on the base substrate; wherein the functional film layer is configured for reflecting light emitted from outside to the functional film layer; the display substrate further includes an encapsulation layer and a blocking layer; the blocking layer is on a side of the functional film layer facing away from the base substrate; the encapsulation layer is between the blocking layer and the functional film layer; an orthographic projection of the blocking layer onto the base substrate at least partially overlaps with an orthographic projection of the functional film layer onto the base substrate.

Optionally, the display substrate includes an active area and a bezel area surrounding the active area; the bezel area includes a bendable area; and at least part of the functional film layer is between the bendable area and the active area.

Optionally, the functional film layer includes at least one part which extends in a first direction;
the blocking layer includes a plurality of first blocking patterns; the first blocking pattern includes at least one part which extends in the first direction; the plurality of first blocking patterns are arranged in a second direction; the second direction intersects the first direction; an orthographic projection of at least part of the plurality of first blocking patterns onto the base substrate at least partially overlaps with the orthographic projection of the functional film layer onto the base substrate.

Optionally, a ratio of a width of the first blocking pattern in a direction perpendicular to an extending direction of the first blocking pattern to a minimum distance between the first blocking pattern and an adjacent first blocking pattern is greater than or equal to 3:2.

Optionally, the display substrate further includes a shielding line; and at least part of the shielding line is located between two adjacent first blocking patterns.

Optionally, a minimum distance between the first blocking pattern and the shielding line is greater than or equal to 4 microns.

Optionally, a minimum distance between the first blocking pattern and the shielding line is equal to 0.4 times a width of the first blocking pattern in a direction perpendicular to an extending direction of the first blocking pattern.

Optionally, the functional film layer includes at least one part which extends in a first direction;
the blocking layer includes an entire second blocking pattern; the second blocking pattern includes a blocking main body part and a blocking extension part which are coupled to each other; the blocking main body part extends in the first direction; an orthographic projection of the blocking main body part onto the base substrate at least partially overlaps with the orthographic projection of the functional film layer onto the base substrate.

Optionally, the blocking extension part is reused as a shielding line in the display substrate.

Optionally, the display substrate further includes an anode layer; the functional film layer and the anode layer are arranged in a same layer and made of a same material; the functional film layer is used as a positive power signal bus or a negative power signal bus in the display substrate.

Optionally, the display substrate further includes an organic layer; an organic groove is defined in the organic layer;
the shielding line is located at one side of the organic layer facing away from the base substrate; the shielding line includes a first shielding part spanning the organic groove; an extension direction of the first shielding part is perpendicular to an extension direction of a boundary of the organic groove spanned by the first shielding part.

Optionally, the organic layer includes a pixel defining layer and a planarization layer; at least part of the planarization layer is between the pixel defining layer and the base substrate; a first organic groove is defined in the pixel defining layer; a second organic groove is defined in the planarization layer; an orthographic projection of the first organic groove onto the base substrate at least partially overlaps with an orthographic projection of the second organic groove onto the base substrate;
the extension direction of the first shielding part is perpendicular to an extension direction of a boundary of the first organic groove spanned by the first shielding part, and is perpendicular to an extension direction of a boundary of the second organic groove spanned by the first shielding part.

Optionally, the display substrate further includes a plurality of touch signal lines; the touch signal line includes a first touch part spanning the organic groove; an extension direction of the first touch part is perpendicular to an extension direction of a boundary of the organic groove spanned by the first touch part.

Optionally, the display substrate further includes a plurality of first virtual patterns arranged in the first direction; the first virtual pattern extends in the second direction; the first virtual pattern spans the organic grooves; and the first virtual patterns and the shielding line are arranged in the same layer and made of a same material.

Optionally, multiple first virtual patterns are divided into multiple first virtual pattern groups; the multiple first virtual pattern groups are arranged in the first direction;
the multiple touch signal lines are divided into multiple touch signal line groups; at least part of the touch signal line groups and the first virtual pattern groups are alternately arranged in the first direction; at least part of the shielding line is located between one touch signal line group and one adjacent first virtual pattern group.

Optionally, at least part of an orthographic projection of the organic groove onto the base substrate is located between the bendable area and the active area.

Optionally, the display substrate further includes a plurality of touch signal lines; the touch signal line includes a first touch part, a second touch part and a third touch part which are connected end to end in sequence; the first touch part and the second touch part are located in the bezel area, and the third touch part is located in the active area;
the second touch parts included in at least part of the touch signal lines forms a winding structure; resistances of the multiple touch signal lines are substantially the same.

Optionally, the second touch part includes a first access end, a second access end and a winding structure; the winding structure is respectively coupled with the first access end and the second access end; the first access end is coupled with the corresponding first touch part; the second access end is coupled with the corresponding third touch part;
the first access end includes at least one part which extends in the second direction, and the second access end includes at least one part which extends in the second direction.

Optionally, a plurality of second access ends included in the multiple touch signal lines are arranged in the first direction; a virtual winding structure is disposed between at least some adjacent second access ends of the plurality of the second access ends.

Optionally, a width of the second access end in a direction perpendicular to an extension direction of the second access end is three times a width of the winding structure.

Optionally, the touch signal line and the blocking layer are arranged in the same layer and made of a same material.

Based on the technical solution of the above display substrate, according to a second aspect of the present disclosure, a touch display device is provided and includes the above display substrate.

### BRIEF DESCRIPTION OF THE DRAWINGS

The drawings are included to provide a better understanding of the present disclosure and constitute a part of the present disclosure. Exemplary embodiments of the present disclosure and the description thereof are used for explaining the present disclosure, and do not constitute an improper limitation on the present disclosure. In the drawings:
FIG. 1 is a schematic diagram of a lower frame structure of a display substrate according to an embodiment of the present disclosure;
FIG. 2 is a schematic enlarged view of partial structures in an X1 part shown in FIG. 1;
FIG. 3 is a schematic enlarged view of another structure adopted at a position where an X1 part is located in FIG. 1;
FIG. 4 is a schematic enlarged view of partial structures in an X2 part shown in FIG. 1;
FIG. 5 is a schematic enlarged view of partial structures in an X3 part shown in FIG. 1;
FIG. 6 is a schematic enlarged view of partial structures in an X4 part shown in FIG. 1;
FIG. 7 is a first cross-sectional schematic view of a display structure part of a display substrate according to an embodiment of the present disclosure;
FIG. 8 is a second cross-sectional schematic view of a display structure part of a display substrate according to an embodiment of the present disclosure;
FIG. 9 is a schematic top view of a display substrate according to an embodiment of the present disclosure;
FIG. 10 is a schematic diagram of a touch electrode layer included in a touch structure part of a display substrate according to an embodiment of the present disclosure;
FIG. 11 is a schematic diagram showing a circuit structure of a low temperature poly silicon (LTPS) mode sub-pixel driver circuit of a display substrate according to an embodiment of the present disclosure;
FIG. 12 is a schematic diagram showing a layout of a low temperature poly silicon (LTPS) mode sub-pixel driver circuit of a display substrate according to an embodiment of the present disclosure;
FIG. 13 is a schematic diagram showing a layout of sub-pixels in an LTPS mode in a display substrate according to an embodiment of the present disclosure;
FIG. 14 is a schematic diagram showing a circuit structure of a low temperature polycrystalline oxide (LTPO) mode sub-pixel driver circuit of a display substrate according to an embodiment of the present disclosure;
FIG. 15 is a schematic diagram showing a layout of a low temperature polycrystalline oxide (LTPO) mode sub-pixel driver circuit of a display substrate according to an embodiment of the present disclosure; and
FIG. 16 is a schematic diagram showing a layout of sub-pixels in an LTPO mode in a display substrate according to an embodiment of the present disclosure.

### DETAILED DESCRIPTION

In order to further illustrate the display substrate and the touch display device according to the embodiments of the present disclosure, detailed descriptions are provided hereinafter in conjunction with the accompanying drawings of the description.

The present disclosure provides a touch display product. The touch display product includes an active area and a bezel area around a periphery of the active area. The bezel area includes a functional film layer which is made of the same material as an anode layer in the active area and which is arranged on the same layer as the anode layer in the active area. The functional film layer can be used as a signal line to realize signal transmission function.

Due to material limitations of the functional film layer, when the touch display product is used in an environment illuminated by strong light, the functional film layer will reflect the light irradiated at a surface thereof, which results in light leakage in the touch display product and affects users' experience.

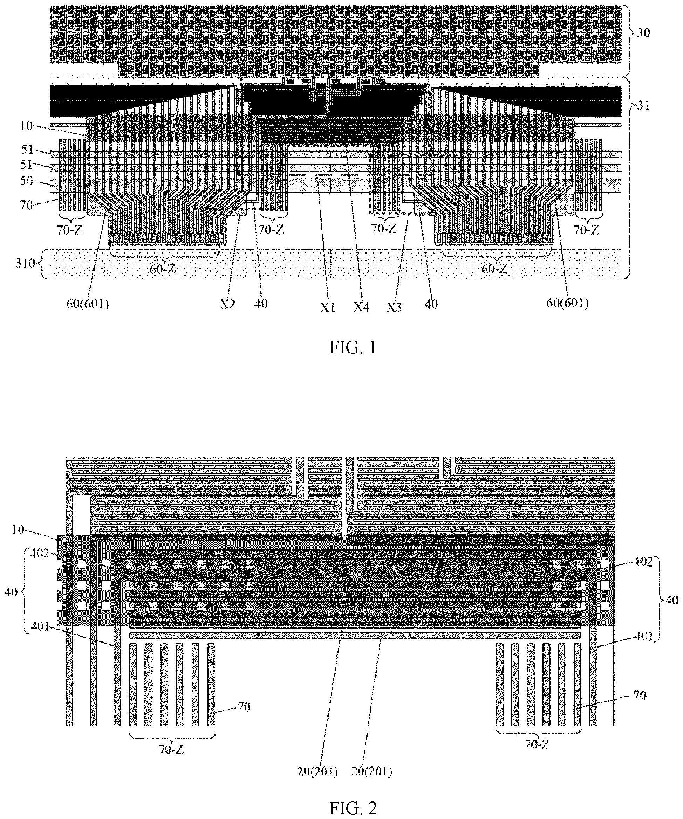

Referring to FIG. 1 to FIG. 3, one embodiment of the present disclosure provides a display substrate, which includes: a base substrate and a functional film layer 10 on the base substrate. The functional film layer 10 is capable of reflecting light emitted from outside to the functional film layer 10. The display substrate further includes an encapsulation layer and a blocking layer 20. The blocking layer 20 is located on a side of the functional film layer 10 facing away from the base substrate. The encapsulation layer is located between the blocking layer 20 and the functional film layer 10. An orthographic projection of the blocking layer 20 onto the base substrate at least partially overlaps with an orthographic projection of the functional film layer 10 onto the base substrate.

Exemplarily, the functional film layer 10 is used as a positive power signal bus in the display substrate. The positive power signal bus is respectively coupled with a driving chip in the display substrate and a power line located in the active area 30 in the display substrate, and transmits a positive power signal provided by the driving chip to the power line.

Exemplarily, the functional film layer 10 is used as a negative power signal bus in the display substrate. The negative power signal bus is respectively coupled with the driving chip in the display substrate and a cathode located in the active area 30 in the display substrate, and transmits a negative power signal provided by the driving chip to the cathode.

Exemplarily, the display substrate further includes an encapsulation layer, and the functional film layer 10 is arranged between the encapsulation layer and the base substrate. The functional film layer 10 is covered by the encapsulation layer. The blocking layer 20 is located on a side of the encapsulation layer facing away from the functional film layer 10 and the base substrate. An orthographic projection of the blocking layer 20 onto the base substrate at least partially overlaps with an orthographic projection of the functional film layer 10 onto the base substrate. Exemplarily, the orthographic projection of the blocking layer 20 onto the base substrate completely covers the orthographic projection of the functional film layer 10 onto the base substrate.

According to the specific structure of the above display substrate, in the display substrate provided in the embodiment of the present disclosure, the blocking layer 20 is arranged on the side of the encapsulation layer facing away from the base substrate, and the orthographic projection of the blocking layer 20 onto the base substrate at least partially overlaps with the orthographic projection of the functional film layer 10 onto the base substrate, so that when external light is irradiated towards the functional film layer 10, the light is blocked by the blocking layer 20, which prevents the light irradiated towards the functional film layer 10 from being reflected by the functional film layer 10, thereby avoiding impact on the user experience caused by the light leakage phenomenon of the display substrate in actual application.

As shown in FIG. 1 to FIG. 3, in some embodiments, the display substrate includes an active area 30 and a bezel area 31 surrounding the active area 30. The bezel area 31 includes a bendable area 310. At least part of the functional film layer 10 is located between the bendable area 310 and the active area 30.

Exemplarily, the bendable area 310 is located at a lower frame of the display substrate, and the functional film layer 10 is located at the lower frame of the display substrate, which are not limited thereto.

Exemplarily, the functional film layer 10 may also be located at an upper frame, a left frame or a right frame of the display substrate. When the functional film layer 10 is located at the upper frame, the left frame or the right frame, the blocking layer 20 may also be arranged to cover the functional film layer 10, thereby avoiding the problem of light leakage caused by light reflected by the functional film layer 10.

As shown in FIG. 1 and FIG. 2, in some embodiments, the functional film layer 10 includes at least one part which extends in a first direction.

The blocking layer 20 includes a plurality of first blocking patterns 201. The first blocking pattern 201 includes at least one part which extends in the first direction. The plurality of first blocking patterns 201 are arranged in a second direction. The second direction intersects the first direction. At least part of orthographic projections of the first blocking patterns 201 onto the base substrate at least partially overlaps with the orthographic projection of the functional film layer 10 onto the base substrate.

Exemplarily, the first direction is a transverse direction, and the second direction is a longitudinal direction, which are not limited thereto.

Exemplarily, the functional film layer 10 includes a plurality of first blocking patterns 201. The first blocking pattern 201 may be a strip-shaped pattern which extends in the first direction, which is not limited thereto.

Exemplarily, an orthographic projection of the first blocking pattern 201 onto the base substrate is covered by the orthographic projection of the functional film layer 10 onto the base substrate.

The above arrangement that the blocking layer 20 includes a plurality of first blocking patterns 201, can effectively reduce layout difficulty of the blocking layer 20 while ensuring the blocking effect of the blocking layer 20.

In some embodiments, a ratio of a width of the first blocking pattern 201 in a direction perpendicular to its own extension direction to a minimum distance between the first blocking pattern 201 and an adjacent first blocking pattern 201 is greater than or equal to 3:2.

In some embodiments, the width of the first blocking pattern 201 in the direction perpendicular to its own extension direction is between 8 microns and 10 microns, and may include endpoint values. Exemplarily, the width of the first blocking pattern 201 in the direction perpendicular to its own extension direction is 9 microns.

As shown in FIG. 1 and FIG. 2, in some embodiments, the minimum distance between adjacent first blocking patterns 201 is between 5 microns and 9 microns, and may include endpoint values. Exemplarily, the minimum distance between adjacent first blocking patterns 201 may be 6 microns, 7 microns, or 8 microns.

The above arrangement of the first blocking patterns 201 can effectively reduce layout difficulty of the blocking layer 20 while ensuring the blocking effect of the blocking layer 20.

As shown in FIG. 1 and FIG. 2, in some embodiments, the display substrate further includes a shielding line 40. At least part of the shielding line 40 is located between two adjacent first blocking patterns 201.

Exemplarily, the shielding line 40 includes a first shielding part 401 and a second shielding part 402 coupled with each other. The first shielding part 401 includes at least one part which extends in the second direction, and the second shielding part 402 includes at least one part which extends in the first direction. Exemplarily, the first shielding part 401 and the second shielding part 402 are formed into an integrated structure, and the second shielding part 402 is located between two adjacent first blocking patterns 201.

Exemplarily, the first shielding part 401 is coupled with the driving chip in the display substrate and receives a ground signal provided by the driving chip.

Exemplarily, an orthographic projection of the shielding line 40 onto the base substrate at least partially overlaps with the orthographic projection of the functional film layer 10 onto the base substrate. The shielding line 40 and the blocking layer 20 are arranged in the same layer and made of the same material.

Exemplarily, the display substrate includes two shielding lines 40. The two shielding lines 40 are arranged to mirror each other. There is a gap between two second shielding parts 402 included in the two shielding lines 40.

The above arrangement that at least part of the shielding line 40 is located between two adjacent first blocking patterns 201, can effectively reduce crosstalk between different structures in the bezel area 31 of the display substrate.

As shown in FIG. 1 and FIG. 2, in some embodiments, the minimum distance between the first blocking pattern and the shielding line is greater than or equal to 4 microns.

As shown in FIG. 1 and FIG. 2, in some embodiments, the minimum distance between the first blocking pattern and the shielding line is equal to 0.4 times the width of the first blocking pattern in the direction perpendicular to the extending direction of the first blocking pattern.

Exemplarily, when 0.4 times the width of the first blocking pattern in the direction perpendicular to the extending direction of the first blocking pattern is less than 4 microns, a value of the minimum distance between the first blocking pattern and the shielding line is greater than or equal to 4 microns. When 0.4 times the width of the first blocking pattern in the direction perpendicular to the extending direction of the first blocking pattern is greater than or equal to 4 microns, the minimum distance between the first blocking pattern and the shielding line is equal to 0.4 times the width of the first blocking pattern in the direction perpendicular to the extending direction of the first blocking pattern.

As shown in FIG. 1 and FIG. 2, in some embodiments, the minimum distance between the first blocking pattern 201 and the shielding line 40 is between 4 microns and 6 microns, and may include endpoint values. Exemplarily, the minimum distance between the first blocking pattern 201 and the shielding line 40 is 5 microns.

The above arrangement of the first blocking pattern 201 and the shielding line 40 can effectively reduce the layout difficulty of the blocking layer 20 and the shielding layer while ensuring the blocking effect of the blocking layer 20 and the shielding effect of the shielding layer.

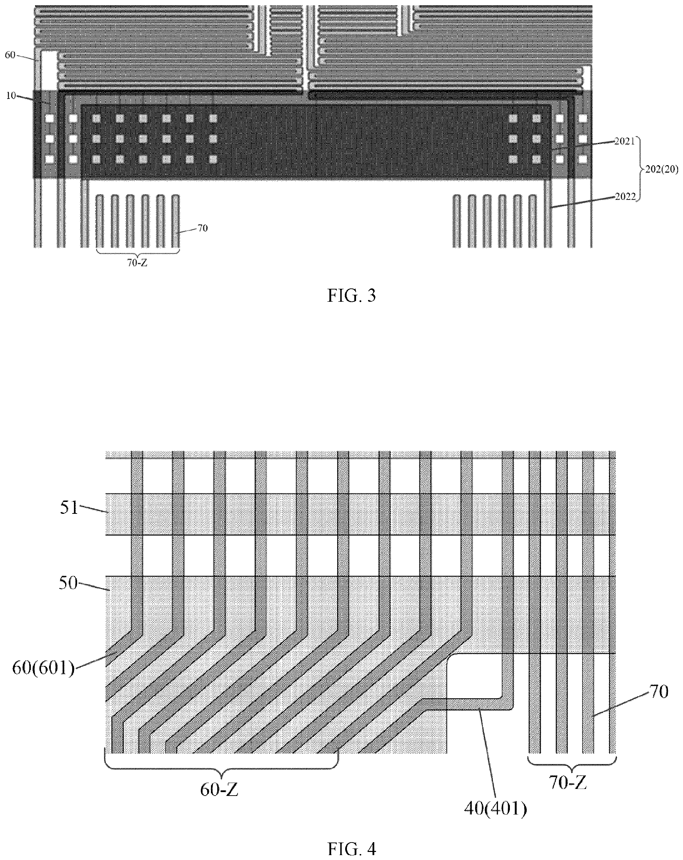

As shown in FIG. 1 and FIG. 3, in some embodiments, the functional film layer 10 includes at least one part which extends in a first direction.

The blocking layer 20 includes an entire second blocking pattern 202. The second blocking pattern 202 includes a blocking main body part 2021 and a blocking extension part 2022 which are coupled to each other. The blocking main body part 2021 extends in the first direction. An orthographic projection of the blocking main body part 2021 onto the base substrate at least partially overlaps with the orthographic projection of the functional film layer 10 onto the base substrate.

Exemplarily, the blocking main body part 2021 and the blocking extension part 2022 are formed into an integrated structure. The blocking main body part 2021 extends in the first direction, and the blocking extension part 2022 includes at least one part which extends in the second direction. The second blocking pattern 202 includes two blocking extension parts 2022, and two ends of the blocking main body part 2021 are respectively coupled with the two blocking extension parts 2022 in a one-to-one correspondence manner.

In the display substrate provided in the above embodiments, the arrangement that the orthographic projection of the blocking main body part 2021 onto the base substrate at least partially overlaps with the orthographic projection of the functional film layer 10 onto the base substrate, can better achieve the light-blocking effect of the blocking layer 20 while reducing resistance of the blocking layer 20.

As shown in FIG. 1 and FIG. 3, in some embodiments, the blocking extension part 2022 is reused as the shielding line 40 in the display substrate.

Exemplarily, the blocking extension part 2022 is coupled with the driving chip included in the display substrate and receives a ground signal provided by the driving chip.

The above arrangement that the blocking extension part 2022 is reused as the shielding line 40 in the display substrate, can not only ensure light-shielding effect of the blocking layer 20, but also prevent the blocking layer 20 from being in a floating state and causing crosstalk with other conductive structures. Further, there is no need to provide additional shielding lines 40 specifically for shielding in the display substrate, which reduces the layout difficulty of the display substrate.

In some embodiments, the display substrate further includes an anode layer. The functional film layer 10 and the anode layer are arranged in the same layer and made of a same material. The functional film layer 10 is used as a positive power signal bus or a negative power signal bus in the display substrate.

Exemplarily, the anode layer is made of indium tin oxide material, the functional film layer 10 and the anode layer are arranged in the same layer and made of a same material, and the functional film layer 10 and the anode layer can be formed at a same time in a same patterning process. The functional film layer 10 may be used as a positive power signal bus or a negative power signal bus in the display substrate, which is not limited thereto.

As shown in FIG. 1, FIG. 4 and FIG. 5, in some embodiments, the display substrate further includes an organic layer. An organic groove 50 is defined in the organic layer.

The shielding line 40 is located at one side of the organic layer facing away from the base substrate. The shielding line 40 includes a first shielding part 401 spanning the organic groove 50. An extension direction of the first shielding part 401 is perpendicular to an extension direction of a boundary of the organic groove 50 spanned by the first shielding part 401.

Exemplarily, the organic layer is located between the base substrate and the encapsulation layer. The encapsulation layer includes a first inorganic encapsulation layer, an organic encapsulation layer and a second inorganic encapsulation layer which are sequentially stacked. Since a depth of the organic groove 50 defined in the organic layer is deeper, the organic encapsulation layer cannot fill the organic groove 50 flatly, so that in an area where the organic groove 50 is located, there is a segment difference in a surface of the encapsulation layer facing away from the base substrate.

Exemplarily, the shielding line 40 is located at one side of the encapsulation layer facing away from the base substrate, and the first shielding part 401 of the shielding line 40 can span the organic groove 50.

In the display substrate provided in the above embodiments, the arrangement that the extension direction of the first shielding part 401 is perpendicular to the extension direction of the boundary of the organic groove 50 spanned by the first shielding part 401, can minimize a contact area between the first shielding part 401 and a segment difference surface formed by the organic groove 50 spanned by the first shielding part 401, at the boundary of the organic groove 50 spanned by the first shielding part 401, which can effectively reduce residue of the first shielding part 401 at the segment difference surface in the process of forming the first shielding part 401 by using a patterning process, thereby reducing risk of short circuit between the first shielding part 401 and other surrounding conductive structure.

In some embodiments, the organic layer includes a pixel defining layer and a planarization layer. At least part of the planarization layer is between the pixel defining layer and the base substrate. A first organic groove is defined in the pixel defining layer. A second organic groove is defined in the planarization layer. An orthographic projection of the first organic groove onto the base substrate at least partially overlaps with an orthographic projection of the second organic groove onto the base substrate.

The extension direction of the first shielding part 401 is perpendicular to an extension direction of a boundary of the first organic groove spanned by the first shielding part 401, and is perpendicular to an extension direction of a boundary of the second organic groove spanned by the first shielding part 401.

Exemplarily, a total depth of the first organic groove and the second organic groove is between 3 microns and 3.5 microns, and may include endpoint values.

Exemplarily, at least part of the planarization layer is located between the pixel defining layer and the base substrate. At least part of the anode layer included in the display substrate is located between the pixel defining layer and the planarization layer.

Exemplarily, an orthographic projection of the first organic groove onto the base substrate at least partially overlaps an orthographic projection of the second organic groove onto the base substrate, with a segment difference of about 3 microns formed. The organic encapsulation layer cannot fill up the segment difference.

In the display substrate provided in the above embodiments, the arrangement that the extension direction of the first shielding part 401 is perpendicular to the extension direction of the boundary of the first organic groove spanned by the first shielding part 401 and is perpendicular to the extension direction of the boundary of the second organic groove spanned by the first shielding part 401, can minimize a contact area between the first shielding part 401 and a segment difference surface formed by the first organic groove spanned by the first shielding part 401 at the boundary of the first organic groove spanned by the first shielding part 401, and minimize a contact area between the first shielding part 401 and a segment difference surface formed by the second organic groove spanned by the first shielding part 401 at the boundary of the second organic groove spanned by the first shielding part 401, which can effectively reduce residue of the first shielding part 401 at the segment difference surfaces in the process of forming the first shielding part 401 by using a patterning process, thereby reducing risk of short circuit between the first shielding part 401 and other surrounding conductive structure.

As shown in FIG. 1, FIG. 4 and FIG. 5, in some embodiments, the display substrate further includes a plurality of touch signal lines 60. The touch signal line 60 includes a first touch part 601 spanning the organic groove 50. An extension direction of the first touch part 601 is perpendicular to an extension direction of a boundary of the organic groove 50 spanned by the first touch part 601.

Exemplarily, the touch signal line 60 is located at one side of the encapsulation layer facing away from the base substrate and is used for transmitting a touch signal.

Exemplarily, the touch signal line 60 may extend from the active area 30 of the display substrate to the lower bezel area of the display substrate. The first touch part 601 included in the touch signal line 60 is located in the lower bezel area.

In the display substrate provided by the above embodiments, the arrangement that the extension direction of the first touch part 601 is perpendicular to the extension direction of the boundary of the organic groove 50 spanned by the first touch part 60, can minimize a contact area between the first touch part 601 and a segment difference surface formed by the organic groove 50 spanned by the first touch part 601, at the boundary of the organic groove 50 spanned by the first touch part 601, which can effectively reduce residue of the first touch part 601 at the segment difference surface in the process of forming the first touch part 601 by using a patterning process, thereby reducing risk of short circuit between the first touch part 601 and other surrounding conductive structure.

As shown in FIG. 1, FIG. 4 and FIG. 5, in some embodiments, the display substrate further includes a plurality of first virtual patterns 70 arranged in the first direction. The first virtual pattern 70 extends in the second direction. The first virtual pattern 70 spans the organic grooves 50. The first virtual patterns 70 and the shielding line 40 are arranged in the same layer and made of a same material.

Exemplarily, the first virtual pattern 70, the touch signal line 60, the shielding line 40 and the blocking layer 20 are all arranged in the same layer and made of a same material, and can be formed at the same time in a same patterning process, thereby effectively simplifying the manufacturing process of the display substrate and reducing the manufacturing cost of the display substrate.

In the display substrate provided in the above embodiments, the above arrangement that a plurality of the first virtual patterns 70 span the organic groove 50, can increase a contact area between a film layer where the first virtual patterns 70, the touch signal line 60, the shielding line 40 and the blocking layer 20 is located, and a lower film layer thereof, thereby increasing a bonding strength between the film layer where the first virtual patterns 70, the touch signal line 60, the shielding line 40 and the blocking layer 20 is located, and the lower film layer thereof, and then improving the yield of the display substrate.

As shown in FIG. 1, in some embodiments, multiple first virtual patterns 70 are divided into multiple first virtual pattern groups 70-Z. The multiple first virtual pattern groups 70-Z are arranged in the first direction.

The multiple touch signal lines 60 are divided into multiple touch signal line groups 60-Z. At least part of the touch signal line groups 60-Z and the first virtual pattern groups 70-Z are alternately arranged in the first direction. At least part of the shielding line 40 is located between one touch signal line group 60-Z and one adjacent first virtual pattern group 70-Z.

Exemplarily, the multiple first virtual patterns 70 are divided into a plurality of first virtual pattern groups 70-Z, and each first virtual pattern group 70-Z includes a plurality of first virtual patterns 70 arranged in the first direction. The multiple touch signal lines 60 are divided into a plurality of touch signal line groups 60-Z, and each touch signal line group 60-Z includes a plurality of touch signal lines 60 arranged in the first direction.

In the display substrate provided in the above embodiments, the above arrangement that at least part of the touch signal line groups 60-Z and the first virtual pattern groups 70-Z are alternately arranged in the first direction and at least part of the shielding line 40 is located between one touch signal line group 60-Z and one adjacent first virtual pattern group 70-Z, can well shield interference caused by the first virtual pattern 70 to the touch signal line 60 through the shielding line 40, thereby ensuring accuracy of a touch signal transmitted by the touch signal line 60.

As shown in FIG. 1, in some embodiments, at least part of an orthographic projection of the organic groove 50 onto the base substrate is located between the bendable area 310 and the active area 30.

Exemplarily, the display substrate further includes a retaining wall structure 51. An orthographic projection of the retaining wall structure 51 onto the base substrate is located between the orthographic projection of the organic groove 50 onto the base substrate and the active area 30.

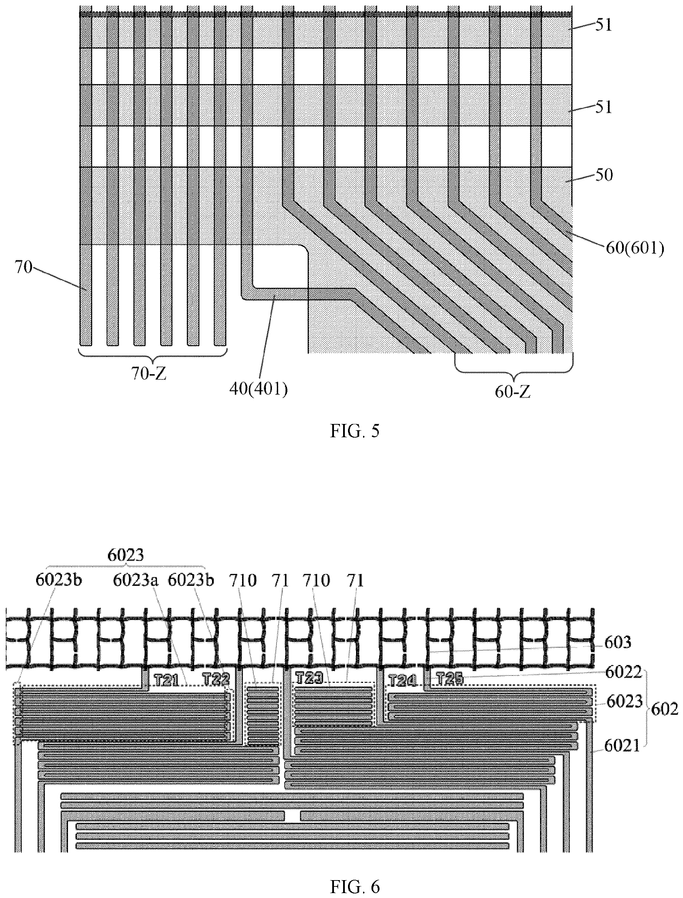

As shown in FIG. 1 and FIG. 6, in some embodiments, the display substrate further includes a plurality of touch signal lines 60. The touch signal line 60 includes a first touch part 601, a second touch part 602 and a third touch part 603 which are connected end to end in sequence. The first touch part 601 and the second touch part 602 are located in the bezel area 31, and the third touch part 603 is located in the active area 30.

The second touch parts 602 included in at least part of the touch signal lines 60 forms a winding structure 6023. Resistances of the multiple touch signal lines 60 are approximately the same.

The winding structure 6023 has various specific structures. Exemplarily, the winding structure 6023 includes a plurality of straight edge parts 6023a and a plurality of corner parts 6023b. The straight edge part 6023a extends in the first direction. The corner part 6023b extends in the second direction. The multiple straight edge parts 6023a are sequentially arranged in the second direction, and the multiple straight edge parts 6023a are sequentially connected end to end. The two connected straight edge parts 6023a are connected through the corner part 6023b, so that the winding structure 6023 is formed into a structure having a shape similar to a shape of a Chinese character " 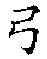 ".

Exemplarily, the winding structure 6023 formed by the second touch parts 602 of each touch signal line 60 may be the same or different, that is, lengths of the second touch parts 602 of each touch signal line 60 may be the same or different.

Exemplarily, by adjusting a winding length of the winding structure 6023 included in the second touch part 602, the resistance of the second touch part 602 can be adjusted, thereby adjusting the resistance of the touch signal line 60.

In the display substrate provided in the above embodiments, the arrangement that the second touch parts 602 included in at least part of the touch signal lines 60 forms the winding structure 6023, enables to adjust overall resistance of each touch signal line 60 by adjusting the winding length of the winding structure 6023 included in the second touch part 602 in each touch signal line 60, so that the resistance of the multiple touch signal lines 60 in the display substrate is approximately the same, thereby effectively improving the accuracy of the touch signal transmitted in the display substrate.

The display substrate provided in the above embodiments can be applied to a flexible single-layer on cell (FSLOC) product in a watch, and can overcome the problem that the resistance compensation of the touch signal line cannot be realized due to insufficient space on the lower bezel of the FSLOC product in the watch. The FSLOC product in the watch may be a self-capacitance touch product.

As shown in FIG. 1 and FIG. 6, in some embodiments, the second touch part 602 includes a first access end 6021, a second access end 6022 and a winding structure 6023. The winding structure 6023 is respectively coupled with the first access end 6021 and the second access end 6022. The first access end 6021 is coupled with the corresponding first touch part 601. The second access end 6022 is coupled with the corresponding third touch part 603.

The first access end 6021 includes at least one part which extends in the second direction, and the second access end 6022 includes at least one part which extends in the second direction.

As shown in FIG. 6, exemplarily, the first access end 6021, the second access end 6022 and the winding structure 6023 are formed into an integrated structure.

Exemplarily, in each of the touch signal lines 60, lengths of the second access ends 6022 included in the second touch parts 602 may be the same or different.

As shown in FIG. 6, exemplarily, the first access end 6021 and the second access end 6022, which belong to the same touch signal line 60, are staggered in the first direction.

In the display substrate provided in the above embodiments, the arrangement that the second touch part 602 includes the first access end 6021, the second access end 6022 and the winding structure 6023, can better utilize a layout space of the lower bezel of the display substrate, thereby effectively reducing the layout difficulty of the touch signal line 60 in the lower bezel area.

As shown in FIG. 6, in some embodiments, a plurality of second access ends 6022 included in the multiple touch signal lines 60 are arranged in the first direction. A virtual winding structure 71 is disposed between at least some adjacent second access ends 6022 of the plurality of the second access ends 6022.

Exemplarily, the virtual winding structure 71 includes a plurality of second virtual patterns 710. The second virtual patterns 710 extend in the first direction, and the second virtual patterns 710 are arranged in the second direction.

As shown in FIG. 1 and FIG. 6, the virtual winding structure 71 is insulated from the touch signal line 60. The virtual winding structure 71 and the touch signal line 60 are arranged in the same layer and made of the same material.

According to the display substrate provided in the above embodiments, the presence of the virtual winding structure 71 is helpful to prevent light leakage in the lower bezel area of the display substrate, and can better ensure uniformity of etching when forming the touch signal line 60.

As shown in FIG. 6, in some embodiments, a width of the second access end 6022 in a direction perpendicular to an extension direction thereof is three times a width of the winding structure.

As shown in FIG. 6, in some embodiments, the width of the second access end 6022 in the direction perpendicular to the extension direction thereof is between 8 microns and 12 microns. It is to be noted that T21, T22, T23, T24 and T25 shown in FIG. 6 are labels of touch signal lines 60.

Exemplarily, the width of the second access end 6022 in the direction perpendicular to the extension direction thereof may be 8 microns, 9 microns, 10 microns, 11 microns, 12 microns and the like, which is not limited thereto.

The second access end of the above sizes is helpful to prevent electrostatic breakdown caused by accumulation of static electricity.

As shown in FIG. 1, FIG. 2 and FIG. 6, in some embodiments, the touch signal line 60 and the blocking layer 20 are arranged in the same layer and made of a same material.

Exemplarily, the display substrate includes a touch electrode layer. The touch electrode layer includes a first conductive layer and a second conductive layer. The first conductive layer is used for forming touch electrodes. The second conductive layer is used for forming an electrode connecting bridge.

Exemplarily, both of the touch signal line 60 and the blocking layer 20 are arranged in the same layer and made of the same material as the first conductive layer.

Exemplarily, both of the touch signal line 60 and the blocking layer 20 are arranged in the same layer and made of the same material as the second conductive layer.

Exemplarily, each of the touch signal line 60 and the blocking layer 20 includes a double-layer structure, one of which is arranged in the same layer and made of a same material as the first conductive layer, and the other layer is arranged in the same layer and made of a same material as the second conductive layer.

Exemplarily, each of the first conductive layer and the second conductive layer adopts a three-layer stack structure of Ti/Al/Ti.

According to the display substrate provided in the above embodiments, the arrangement that the touch signal line 60 and the blocking layer 20 are arranged in the same layer and made of the same material, allows the touch signal line 60 to be formed simultaneously with the blocking layer 20 in the same patterning process, thereby effectively simplifying the manufacturing process of the display substrate and reducing the manufacturing cost of the display substrate.

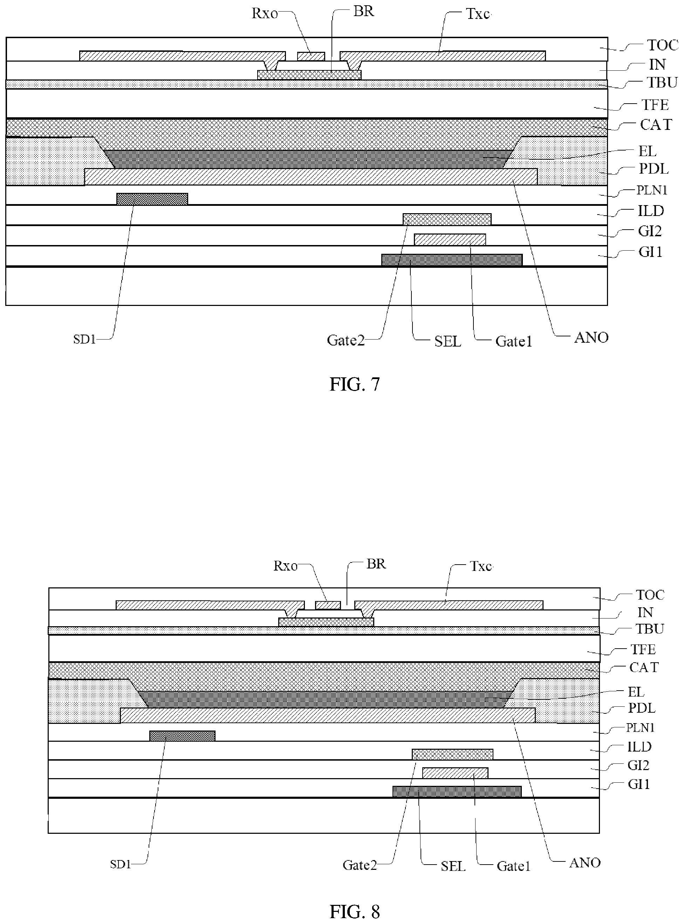

As shown in FIG. 7, the display substrate includes a display structure part and a touch structure part. Exemplarily, the display structure part includes a light-shielding metal layer SEL, a first insulation layer (not shown), an active layer (not shown), a first gate insulation layer GI1, a first gate metal layer Gate1, a second gate insulation layer GI2, a second gate metal layer Gate2, an interlayer insulation layer ILD, a first source-drain metal layer SD1, a first planarization layer PLN1, an anode layer ANO, a pixel defining layer PDL, a electroluminescent functional layer EL, a cathode layer CAT and an encapsulation layer TFE, which are stacked sequentially. The touch structure part includes an inorganic layer TBU, a second conductive layer (used for forming an electrode connecting bridge BR), a second insulation layer IN2 and a first conductive layer (used for forming touch electrodes: RXO, TXC) and a third planarization layer PLN3, which are stacked sequentially.

As shown in FIG. 8, the display structure part may also adopt a double-layer source-drain metal layer structure, that is, the display structure part includes a light-shielding metal layer SEL, a first insulation layer (not shown), an active layer (not shown), a first gate insulation layer GI1, a first gate metal layer Gate1, a second gate insulation layer GI2, a second gate metal layer Gate2, an interlayer insulation layer ILD, a first source-drain metal layer SD1, a first planarization layer PLN1, a second source-drain metal layer SD2, a second planarization layer PLN2, an anode layer ANO, a pixel defining layer PDL, a electroluminescent functional layer EL, a cathode layer CAT and an encapsulation layer TFE, which are stacked sequentially. The touch structure part includes an inorganic layer TBU, a second conductive layer (used for forming an electrode connecting bridge BR), a second insulation layer IN2 and a first conductive layer (used for forming touch electrodes: RXO, TXC) and a third planarization layer TOC PLN3, which are stacked sequentially.

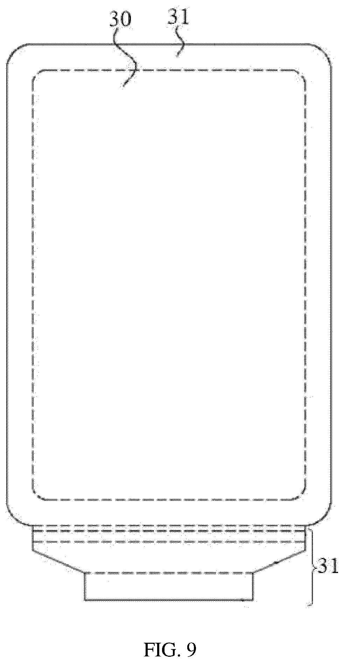

As shown in FIG. 9, the display substrate includes an active area 30 and a bezel area 31. An orthographic projection of a touch electrode layer in the touch structure part onto a base substrate of the display substrate is located in the active area. An orthographic projection of a touch signal line 60 in the touch structure part onto the base substrate, and an orthographic projection of the blocking layer 20 onto the base substrate are located in the bezel area 31.

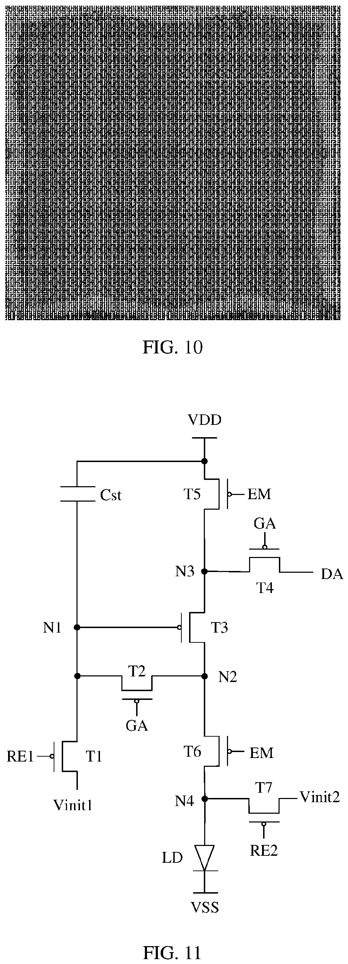

As shown in FIG. 10, FIG. 10 is a schematically top view of a touch electrode layer provided in an embodiment of the present disclosure. An orthographic projection of the touch electrode layer onto the base substrate shown in FIG. 10 is located in the active area 30 shown in FIG. 9. The touch electrode layer shown in FIG. 10 adopts a self-capacitance touch technology.

In the display substrate provided in the above embodiments of the present disclosure, the display structure part includes a plurality of sub-pixels. Each sub-pixel includes a sub-pixel driver circuit and a light-emitting device which are coupled to each other. The sub-pixel driver circuit is used for providing a driving signal for the light-emitting device so as to drive the light-emitting device to emit light, thereby realizing display function of the display substrate.

The sub-pixel driver circuit may adopt LTPS and LTPO modes, which are described hereinafter.

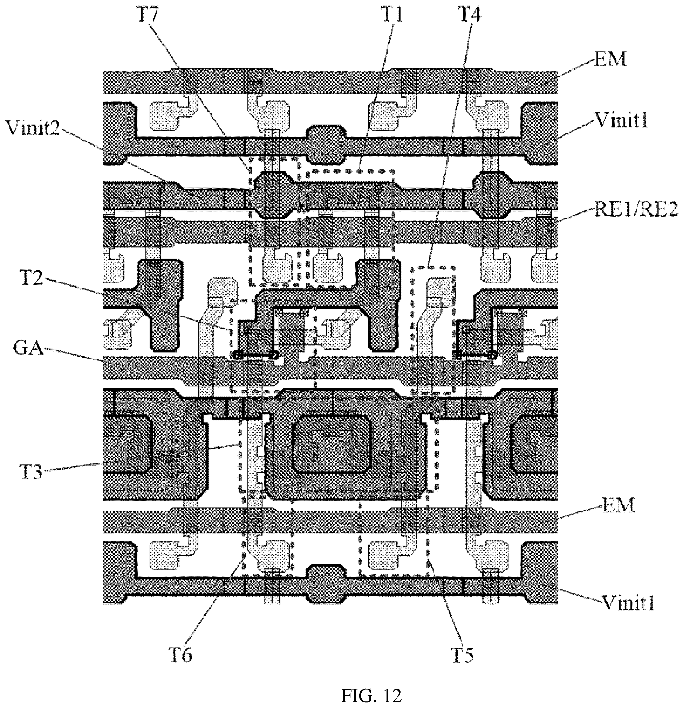

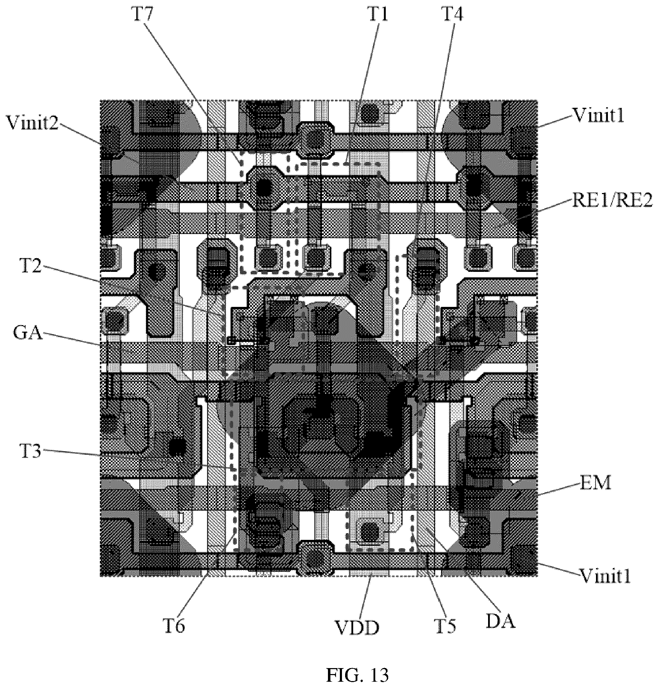

As shown in FIG. 11 to FIG. 13, the sub-pixel driver circuit adopts an LTPS mode.

The sub-pixel driver circuit includes a first transistor T1, a second transistor T2, a third transistor T3, a fourth transistor T4, a fifth transistor T5, a sixth transistor T6, a seventh transistor T7 and a storage capacitor Cst.

The display substrate includes a power line VDD, a data line DA, a gate line GA, a light-emitting control line EM, a first reset line RE1, a second reset line RE2, a first initialization signal line Vinit1 and a second initialization signal line Vinit2.

A gate electrode of the first transistor T1 is coupled with a corresponding first reset line RE1; a first electrode of the first transistor T1 is coupled with a corresponding first initialization signal line Vinit1; and a second electrode of the first transistor T1 is coupled with a gate electrode (that is, a first node N1) of the third transistor T3. A gate electrode of the third transistor T3 is reused as a first plate of the storage capacitor Cst. A second plate of the storage capacitor Cst is coupled with the power line VDD.

A gate electrode of the second transistor T2 is coupled with a corresponding gate line GA; a first electrode of the second transistor T2 is coupled with a second electrode (that is, a second node N2) of the third transistor T3 (that is, a driving transistor); and a second electrode of the second transistor T2 is coupled with the gate electrode of the third transistor T3.

A gate electrode of the fourth transistor T4 is coupled with a corresponding gate line GA; a first electrode of the fourth transistor T4 is coupled with a corresponding data line DA; and a second electrode of the fourth transistor T4 is coupled with a first electrode (that is, a third node N3) of the third transistor T3.

A gate electrode of the fifth transistor T5 is coupled with a corresponding light-emitting control line EM; a first electrode of the fifth transistor T5 is coupled with the power line VDD; and a second electrode of the fifth transistor T5 is coupled with the first electrode of the third transistor T3.

A gate electrode of the sixth transistor T6 is coupled with a corresponding light-emitting control line EM; a first electrode of the sixth transistor T6 is coupled with the second electrode of the third transistor T3; and a second electrode of the sixth transistor T6 is coupled with an anode (that is, a fourth node N4) of the light-emitting device LD.

A gate electrode of the seventh transistor T7 is coupled with the second reset line RE2; a first electrode of the seventh transistor T7 is coupled with the second initialization signal line Vinit2; a second electrode of the seventh transistor T7 is coupled with an anode electrode of the light-emitting device LD. A cathode electrode of the light-emitting device LD receives a negative power supply signal VSS.

When the sub-pixel driver circuit of the above structures is in operation, each operation cycle includes a first reset period, a write-in compensation period, a second reset period and a light-emitting period.

In the first reset period, a reset signal input from the first reset line RE1 is at an effective level, the first transistor T1 is turned on, and a first initialization signal transmitted by the first initialization signal line Vinit1 is input to the gate electrode of the third transistor T3, so that a gate-to-source voltage Vgs maintained on the third transistor T3 in a previous frame is cleared to reset the gate electrode of the third transistor T3.

In the write-in compensation period, the reset signal is at a non-effective level, the first transistor T1 is turned off, a gate scanning signal input from the gate line GA is at an effective level so that the second transistor T2 and the fourth transistor T4 are controlled to be turned on, a data signal is written in the data line DA and is transmitted to the first electrode of the third transistor T3 through the fourth transistor T4. Meanwhile, the second transistor T2 and the fourth transistor T4 are turned on, so that the third transistor T3 acts as a diode structure. In this way, threshold voltage compensation of the third transistor T3 is achieved through the cooperative operation of the second transistor T2, the third transistor T3 and the fourth transistor T4. When compensation time is long enough, a voltage value at the gate electrode of the third transistor T3 is controlled to finally reach Vdata+Vth, where Vdata represents a data signal voltage value, and Vth represents a threshold voltage value of the third transistor T3.

In a second reset period, the gate scanning signal is at a non-effective level, the second transistor T2 and the fourth transistor T4 are both turned off, a reset signal input by the second reset line RE2 (which may optionally be the first reset line to which an adjacent next row of sub-pixel drive circuits are coupled) is at an effective level, the seventh transistor T7 is controlled to be turned on, an initialization signal input by the second initialization signal line Vinit2 is input to the anode of the light-emitting device LD, thereby controlling the light-emitting device LD to emit light.

In the light-emitting period, a light-emitting control signal written by the light-emitting control line EM is at an effective level, the fifth transistor T5 and the sixth transistor T6 are controlled to be turned on, so that a power supply signal transmitted by the power line VDD is input to the first electrode of the third transistor T3. Meanwhile, the voltage value at the gate electrode of the third transistor T3 is maintained at Vdata+Vth, so that the third transistor T3 is turned on, and the gate-to-source voltage value corresponding to the third transistor T3 is Vdata+Vth-Vdd, where Vdd is a voltage value corresponding to the power supply signal. A leakage current generated based on the gate-to-source voltage flows to the anode of the corresponding light-emitting device LD, and drives the corresponding light-emitting device LD to emit light.

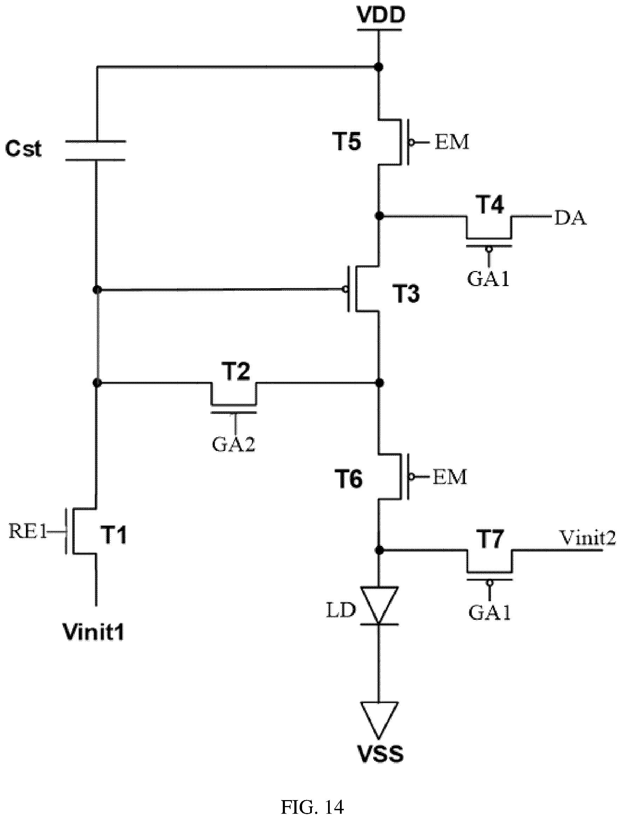

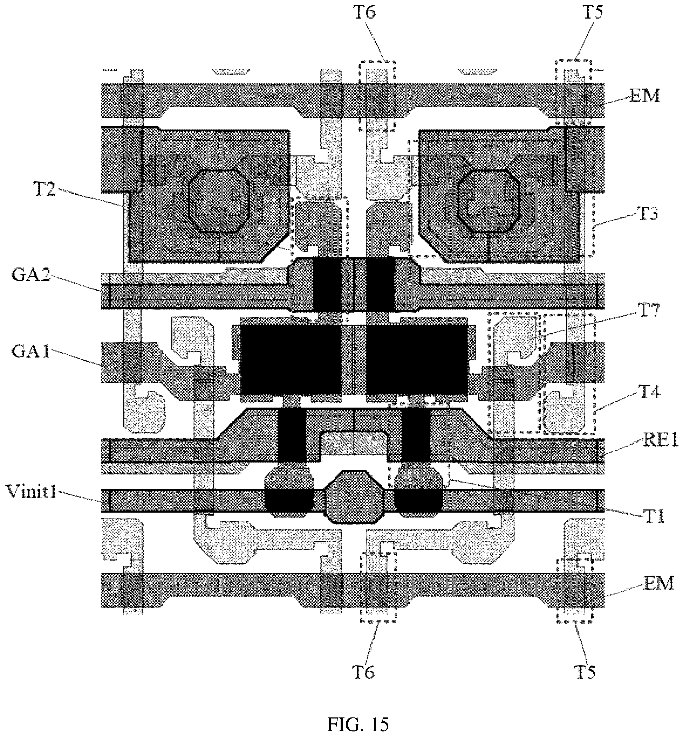

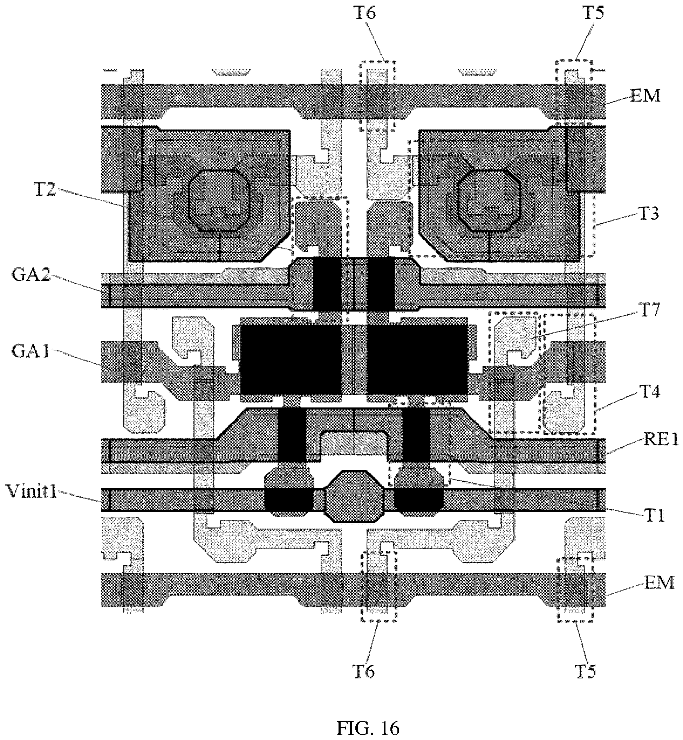

As shown in FIG. 14 to FIG. 16, the sub-pixel driver circuit adopts an LTPO mode.

The sub-pixel driver circuit includes a first transistor T1, a second transistor T2, a third transistor T3, a fourth transistor T4, a fifth transistor T5, a sixth transistor T6, a seventh transistor T7 and a storage capacitor Cst.

The display substrate includes a power line VDD, a data line DA, a first grid line GA1, a second grid line GA2, a light-emitting control line EM, a first reset line RE1, a first initialization signal line Vinit1 and a second initialization signal line Vinit2.

A gate electrode of the first transistor T1 is coupled with a corresponding first reset line RE1; a first electrode of the first transistor T1 is coupled with a corresponding first initialization signal line Vinit1; and a second electrode of the first transistor T1 is coupled with a gate electrode of the third transistor T3. The gate electrode of the third transistor T3 is reused as a first plate of the storage capacitor Cst, and a second plate of the storage capacitor Cst is coupled with the power line VDD.

A gate electrode of the second transistor T2 is coupled with a corresponding second gate line GA2; a first electrode of the second transistor T2 is coupled with a second electrode of the third transistor T3; and a second electrode of the second transistor T2 is coupled with the gate electrode of the third transistor T3.

A gate electrode of the fourth transistor T4 is coupled with a corresponding first gate line GA1; a first electrode of the fourth transistor T4 is coupled with the corresponding data line DA; and a second electrode of the fourth transistor T4 is coupled with a first electrode of the third transistor T3.

A gate electrode of the fifth transistor T5 is coupled with a corresponding light-emitting control line EM; a first electrode of the fifth transistor T5 is coupled with the power line VDD; and a second electrode of the fifth transistor T5 is coupled with the first electrode of the third transistor T3.

A gate electrode of the sixth transistor T6 is coupled with a corresponding light-emitting control line EM; a first electrode of the sixth transistor T6 is coupled with the second electrode of the third transistor T3; and a second electrode of the sixth transistor T6 is coupled with an anode of the light-emitting device LD.

A gate electrode of the seventh transistor T7 is coupled with a corresponding first gate line GA1; a first electrode of the seventh transistor T7 is coupled with the second initialization signal line Vinit2; a second electrode of the seventh transistor T7 is coupled with the anode of the light-emitting device. A cathode of the light-emitting device LD receives a negative power supply signal VSS.

One embodiment of the present disclosure further provides a touch display device which includes the display substrate provided in the embodiments.

It is to be noted that the touch display device may be any product or component with a touch display function, such as a television, a monitor, a digital photo frame, a mobile phone, a tablet computer. The touch display device further includes a flexible circuit board, a printed circuit board, a back plate, etc.

In the display substrate provided in the above embodiments, the blocking layer 20 is arranged on the side of the encapsulation layer facing away from the base substrate, and the orthographic projection of the blocking layer 20 onto the base substrate at least partially overlaps with the orthographic projection of the functional film layer 10 onto the base substrate, so that when external light is irradiated towards the functional film layer 10, the light is blocked by the blocking layer 20, which prevents the light irradiated towards the functional film layer 10 from being reflected by the functional film layer 10, thereby avoiding impact on the user experience caused by the light leakage phenomenon of the display substrate in actual application.

In the display substrate provided in the above embodiments, the arrangement that the shielding line 40 is disposed with the extension direction of the first shielding part 401 included in the shielding line 40 is perpendicular to the extension direction of the boundary of the organic groove 50 spanned by the first shielding part 401, can minimize a contact area between the first shielding part 401 and a segment difference surface formed by the organic groove 50 spanned by the first shielding part 401, at the boundary of the organic groove 50 spanned by the first shielding part 401, which can effectively reduce residue of the first shielding part 401 at the segment difference surface in the process of forming the first shielding part 401 by using a patterning process, thereby reducing risk of short circuit between the first shielding part 401 and other surrounding conductive structure.

In the display substrate provided in the above embodiments, the arrangement that the second touch parts 602 included in at least part of the touch signal lines 60 forms the winding structure 6023, enables to adjust overall resistance of each touch signal line 60 by adjusting the winding length of the winding structure 6023 included in the second touch part 602 in each touch signal line 60, so that the resistance of the multiple touch signal lines 60 in the display substrate is approximately the same, thereby effectively improving the accuracy of the touch signal transmitted in the display substrate.

Therefore, when the touch display device provided in the embodiment of the present disclosure includes the above display substrate, the touch display device also has the above beneficial effects, which are not described again here.

It is to be noted that one signal line extending in a certain direction means that the signal line includes a main part and a secondary part connected to the main part, the main part is a line, line segment or bar-shaped body, the main part extends in a certain direction, and an extension length of the main part along the certain direction is greater than an extension length of the secondary part along other directions.

It is to be noted that the "same layer" in the embodiments of the present disclosure may refer to film layers on a same layer. Or, for example, film layers in the same layer may be a layer structure formed by using the same film formation process to form a film layer for forming specific patterns and then using the same mask to pattern the film layer through a patterning process. Depending on the specific patterns, one patterning process may include multiple exposure, development or etching processes, and specific patterns in the formed layer structure may be continuous or discontinuous. These specific patterns may also be at different heights or have different thicknesses.

In the various method embodiments of the present disclosure, serial numbers of various steps cannot be used to limit sequence of various steps. For those of ordinary skill in the art, without exerting creative work, changes to the sequence of various steps are also within the protection scope of the present disclosure.

It is to be noted that the various embodiments in this specification are described in a progressive manner. Each embodiment focuses on differences from other embodiments, and the same or similar parts between the various embodiments may be referred to each other. In particular, for the method embodiment, since it is basically similar to the product embodiment, the description is relatively simple, and relevant details can be found in the description of the product embodiment.

Unless otherwise defined, any technical or scientific terms used herein shall have the common meaning understood by a person of ordinary skills. Such words as "first" and "second" used in the specification and claims are merely used to differentiate different components rather than to represent any order, number or importance. Similarly, such words as "including" or "comprising" mean that an element or thing appearing before the word includes elements or things listed after the word and their equivalents, without excluding other elements or things. Such words as "connect", "coupling" or "connected to" may include electrical connection, direct or indirect, rather than being limited to physical or mechanical connection. Such words as "on/above", "under/below", "left" and "right" are merely used to represent relative position relationship, and when an absolute position of an object is changed, the relative position relationship will be changed too.

It is to be understood that when an element such as a layer, film, area or substrate is referred to as being "on" or "under" another element, the element may be "directly on" or "under" the another element, or an intermediate element may be present.

In the description of the above embodiments, specific features, structures, materials, or characteristics may be combined in any suitable manner in any one or more embodiments or examples.

The above are merely the optional embodiments of the present disclosure and shall not be used to limit the scope of the present disclosure. It should be noted that, a person skilled in the art may make improvements and modifications without departing from the principle of the present disclosure, and these improvements and modifications shall also fall within the scope of the present disclosure. Therefore, the protection scope of the present disclosure is subject to the protection scope of the claims.

## Claims

1. A display substrate, comprising: a base substrate and a functional film layer on the base substrate; wherein the functional film layer is configured for reflecting light emitted from outside to the functional film layer; the display substrate further includes an encapsulation layer and a blocking layer; the blocking layer is on a side of the functional film layer facing away from the base substrate; the encapsulation layer is between the blocking layer and the functional film layer; an orthographic projection of the blocking layer onto the base substrate at least partially overlaps with an orthographic projection of the functional film layer onto the base substrate.

2. The display substrate according to claim 1, wherein the display substrate includes an active area and a bezel area surrounding the active area; the bezel area includes a bendable area; and at least part of the functional film layer is between the bendable area and the active area.

3. The display substrate according to claim 2, wherein the functional film layer includes at least one part which extends in a first direction;
the blocking layer includes a plurality of first blocking patterns; the first blocking pattern includes at least one part which extends in the first direction; the plurality of first blocking patterns are arranged in a second direction; the second direction intersects the first direction; an orthographic projection of at least part of the plurality of first blocking patterns onto the base substrate at least partially overlaps with the orthographic projection of the functional film layer onto the base substrate.

4. The display substrate according to claim 3, wherein a ratio of a width of the first blocking pattern in a direction perpendicular to an extending direction of the first blocking pattern to a minimum distance between the first blocking pattern and an adjacent first blocking pattern is greater than or equal to 3:2.

5. The display substrate according to claim 3, wherein the display substrate further includes a shielding line; and at least part of the shielding line is located between two adjacent first blocking patterns.

6. The display substrate according to claim 5, wherein a minimum distance between the first blocking pattern and the shielding line is greater than or equal to 4 microns.

7. The display substrate according to claim 5, wherein a minimum distance between the first blocking pattern and the shielding line is equal to 0.4 times a width of the first blocking pattern in a direction perpendicular to an extending direction of the first blocking pattern.

8. The display substrate according to claim 2, wherein the functional film layer includes at least one part which extends in a first direction;
the blocking layer includes an entire second blocking pattern; the second blocking pattern includes a blocking main body part and a blocking extension part which are coupled to each other; the blocking main body part extends in the first direction; an orthographic projection of the blocking main body part onto the base substrate at least partially overlaps with the orthographic projection of the functional film layer onto the base substrate.

9. The display substrate according to claim 8, wherein the blocking extension part is reused as a shielding line in the display substrate.

10. The display substrate according to any one of claims 1 to 9, wherein the display substrate further includes an anode layer; the functional film layer and the anode layer are arranged in a same layer and made of a same material; the functional film layer is used as a positive power signal bus or a negative power signal bus in the display substrate.

11. The display substrate according to claim 6 or 9, wherein the display substrate further includes an organic layer; an organic groove is defined in the organic layer;
the shielding line is located at one side of the organic layer facing away from the base substrate; the shielding line includes a first shielding part spanning the organic groove; an extension direction of the first shielding part is perpendicular to an extension direction of a boundary of the organic groove spanned by the first shielding part.

12. The display substrate according to claim 11, wherein the organic layer includes a pixel defining layer and a planarization layer; at least part of the planarization layer is between the pixel defining layer and the base substrate; a first organic groove is defined in the pixel defining layer; a second organic groove is defined in the planarization layer; an orthographic projection of the first organic groove onto the base substrate at least partially overlaps with an orthographic projection of the second organic groove onto the base substrate;
the extension direction of the first shielding part is perpendicular to an extension direction of a boundary of the first organic groove spanned by the first shielding part, and is perpendicular to an extension direction of a boundary of the second organic groove spanned by the first shielding part.

13. The display substrate according to claim 11, wherein the display substrate further includes a plurality of touch signal lines; the touch signal line includes a first touch part spanning the organic groove; an extension direction of the first touch part is perpendicular to an extension direction of a boundary of the organic groove spanned by the first touch part.

14. The display substrate according to claim 13, wherein the display substrate further includes a plurality of first virtual patterns arranged in the first direction; the first virtual pattern extends in the second direction; the first virtual pattern spans the organic grooves; and the first virtual patterns and the shielding line are arranged in the same layer and made of a same material.

15. The display substrate according to claim 14, wherein multiple first virtual patterns are divided into multiple first virtual pattern groups; the multiple first virtual pattern groups are arranged in the first direction;
the multiple touch signal lines are divided into multiple touch signal line groups; at least part of the touch signal line groups and the first virtual pattern groups are alternately arranged in the first direction; at least part of the shielding line is located between one touch signal line group and one adjacent first virtual pattern group.

16. The display substrate according to claim 11, wherein at least part of an orthographic projection of the organic groove onto the base substrate is located between the bendable area and the active area.

17. The display substrate according to claim 2, wherein the display substrate further includes a plurality of touch signal lines; the touch signal line includes a first touch part, a second touch part and a third touch part which are connected end to end in sequence; the first touch part and the second touch part are located in the bezel area, and the third touch part is located in the active area;
the second touch parts included in at least part of the touch signal lines forms a winding structure; resistances of the multiple touch signal lines are substantially the same.

18. The display substrate according to claim 17, wherein the second touch part includes a first access end, a second access end and a winding structure; the winding structure is respectively coupled with the first access end and the second access end; the first access end is coupled with the corresponding first touch part; the second access end is coupled with the corresponding third touch part;
the first access end includes at least one part which extends in the second direction, and the second access end includes at least one part which extends in the second direction.

19. The display substrate according to claim 18, wherein a plurality of second access ends included in the multiple touch signal lines are arranged in the first direction; a virtual winding structure is disposed between at least some adjacent second access ends of the plurality of the second access ends.

20. The display substrate according to claim 18, wherein a width of the second access end in a direction perpendicular to an extension direction of the second access end is three times a width of the winding structure.

21. The display substrate according to claim 17, wherein the touch signal line and the blocking layer are arranged in the same layer and made of a same material.

22. A touch display device, comprising: the display substrate according to any one of claims 1 to 21.
